(19) Europäisches Patentamt
European Patent Office
Office européen des brevets

(11) **EP 4 137 831 A1**

(12) **EUROPÄISCHE PATENTANMELDUNG**

(43) Veröffentlichungstag:
**22.02.2023 Patentblatt 2023/08**

(21) Anmeldenummer: **21192300.8**

(22) Anmeldetag: **20.08.2021**

(51) Internationale Patentklassifikation (IPC):
**G01R 31/389** (2019.01)  **G01R 31/392** (2019.01)
**H02J 7/00** (2006.01)

(52) Gemeinsame Patentklassifikation (CPC):
**G01R 31/392; G01R 31/389; H02J 7/005**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Hilti Aktiengesellschaft
9494 Schaan (LI)**

(72) Erfinder:
• **Braun, Philipp
87600 Kaufbeuren (DE)**
• **Ender, Moses
9470 Buchs (CH)**
• **Stanger, Robert
87600 Kaufbeuren (DE)**

(74) Vertreter: **Hilti Aktiengesellschaft
Corporate Intellectual Property
Feldkircherstrasse 100
Postfach 333
9494 Schaan (LI)**

(54) **VERFAHREN ZUM BESTIMMEN DES GESUNDHEITSZUSTANDS EINES AKKUMULATORS**

(57) Verfahren zum Steuern und Regeln eines Akkumulators mit wenigstens einer Energiespeicherzelle, wenigstens einen Temperatursensor, eine Strommesseinrichtung, eine Spannungsmesseinrichtung sowie eine Akku-Steuerungseinrichtung mit wenigstens einer Akku-Speichereinrichtung enthält.

Das Verfahren enthält die Verfahrensschritte:
- Einstellen des Akkumulators von einem ersten Ladezustand in einen zweiten Ladezustand;
- Erstellen eines ersten Stromstärkewertes nach Ablauf einer ersten vorbestimmten Zeitdauer, nach Erreichen eines vorbestimmten Temperaturwertes, nach Erreichen eines vorbestimmten Stromstärkewertes oder wenn die Differenz zwischen einem ersten und zweiten ermittelten Stromstärkewert einen vorbestimmten Schwellwert erreicht;
- Ermitteln eines ersten Spannungswertes nach Erreichen des ersten Stromstärkewerts;
- Einstellen eines zweiten Stromstärkewertes nach Ablauf einer zweiten vorbestimmten Zeitdauer;
- Ermitteln eines zweiten Spannungswertes nach Erreichen des zweiten Stromstärkewerts; und
- Bestimmen eines ersten Impedanzwertes des Akkumulators aus dem Quotienten der Differenz des ersten und zweiten Stromstärkewerts sowie der Differenz des ersten und zweiten Spannungswerts.

Akkumulator und Ladegerät zum Durchführen des Verfahrens.

Fig. 1a

EP 4 137 831 A1

**Beschreibung**

Die vorliegende Erfindung betrifft ein Verfahren zum Steuern und Regeln eines Akkumulators zur Versorgung einer Werkzeugmaschine mit elektrischer Energie, wobei der Akkumulator wenigstens eine Energiespeicherzelle, wenigstens einen Temperatursensor, eine Strommesseinrichtung, eine Spannungsmesseinrichtung sowie eine Akku-Steuerungseinrichtung mit wenigstens einer Akku-Speichereinrichtung enthält.

Des Weiteren betrifft die vorliegende Erfindung einen Akkumulator zum Durchführen des Verfahrens.

Darüber hinaus betrifft die vorliegende Erfindung ein Ladegerät zum Durchführen des Verfahrens.

Akkumulatoren werden oftmals zur Versorgung unterschiedlicher Vorrichtungen bzw. Maschinen mit elektrischer Energie verwendet. Die Verwendung von Akkumulatoren zur Versorgung von Werkzeugmaschinen, wie z.B. Bohrmaschinen, Bohrhämmer, Sägen, Schleifgeräte, Schrauber oder dergleichen, ist ebenfalls weitestgehend bekannt. Üblicherweise weisen Akkumulatoren eine Vielzahl an Energiespeicherzellen (auch Zellen oder Akku-Zellen genannt) zum Speichern bzw. Bereitstellen der elektrischen Energie auf. Die Technologie der Energiespeicherzellen kann dabei z.B. auf Li-Ion, Li-Polymer, Li-Metal, Ni-Cd, Ni-MH oder dergleichen basieren.

Die Kapazität bzw. die tatsächliche Leistungsfähigkeit der Energiespeicherzellen können sich über die Lebensdauer des Akkumulators durch verschiedene Alterungsmechanismen ändern bzw. verringern. Typischerweise verliert ein Akkumulator im Laufe seines Lebenszyklus an Kapazität und Leistungsfähigkeit, dieser Verlust hat einen direkten Einfluss auf den sogenannten "Gesundheitszustand" des Akkumulators. Der akute Gesundheitszustand eines Akkumulators wird oft auch als "State of Health" (SOH) bezeichnet.

Das korrekte bzw. genaue Bestimmen der tatsächlichen Kapazität bzw. des SOH eines Akkumulators ist notwendig, um den genauen Verwendungszeitraum bzw. die verbleibende Einsatzmöglichkeit eines Akkumulators als Energieversorgung ermitteln zu können. Ungenaue Angaben bzgl. der Kapazität bzw. Leistungsfähigkeit eines Akkumulators können dazu führen, dass ein Anwender von einer viel höheren (Rest-)Kapazität bzw. Leistungsfähigkeit eines Akkumulators ausgeht als wirklich zur Verfügung steht. Durch das Verwenden von Akkumulatoren mit einer unerwarteten zu geringen (Rest-)Kapazität bzw. Leistungsfähigkeit kann der Einsatz beispielsweise einer akkubetriebenen Werkzeugmaschine diskontinuierlich und deren Verwendung entsprechend ineffizient werden lassen.

Ebenso ist das korrekte bzw. genaue Bestimmen der tatsächlichen Kapazität bzw. des SOH eines Akkumulators erforderlich, um für ein schnelles und effektives Laden des Akkumulators die notwendige Lademenge an elektrischer Energie sowie die tatsächliche Ladezeit bestimmen zu können, wenn der Akkumulator durch ein Ladegerät geladen wird.

Es ist somit Aufgabe der vorliegenden Erfindung das vorstehend erwähnte Problem zu lösen und Verfahren zum Steuern und Regeln eines Akkumulators bereitzustellen, welches ein möglichst genaues Bestimmen der Kapazität bzw. Leistungsfähigkeit eines Akkumulator gewährleisten kann. Darüber hinaus ist es auch Aufgabe einen Akkumulator sowie ein Ladegerät zum Durchführen des Verfahrens bereitzustellen, wodurch ein möglichst genaues Bestimmen der Kapazität bzw. Leistungsfähigkeit eines Akkumulator gewährleistet werden kann.

Die Aufgabe wird gelöst durch den Gegenstand in Anspruch 1, 3 und 4. Vorteilhafte Ausführungsformen sind in den entsprechenden Unteransprüchen aufgeführt.

Die Aufgabe wird dabei gelöst durch ein Verfahren zum Steuern und Regeln eines Akkumulators zur Versorgung einer Werkzeugmaschine mit elektrischer Energie, wobei der Akkumulator wenigstens eine Energiespeicherzelle, wenigstens einen Temperatursensor, eine Strommesseinrichtung, eine Spannungsmesseinrichtung sowie eine Akku-Steuerungseinrichtung mit wenigstens einer Akku-Speichereinrichtung enthält.

Erfindungsgemäß enthält das Verfahren die Verfahrensschritte:

-   Einstellen des Akkumulators von einem ersten Ladezustand in einen zweiten Ladezustand;
-   Erstellen eines ersten Stromstärkewertes nach Ablauf einer ersten vorbestimmten Zeitdauer, nach Erreichen eines vorbestimmten Temperaturwertes, nach Erreichen eines vorbestimmten Stromstärkewertes oder wenn die Differenz zwischen einem ersten und zweiten ermittelten Stromstärkewert einen vorbestimmten Schwellwert erreicht;
-   Ermitteln eines ersten Spannungswertes nach Erreichen des ersten Stromstärkewerts;
-   Einstellen eines zweiten Stromstärkewertes nach Ablauf einer zweiten vorbestimmten Zeitdauer;
-   Ermitteln eines zweiten Spannungswertes nach Erreichen des zweiten Stromstärkewerts; und
-   Bestimmen eines ersten Impedanzwertes des Akkumulators aus dem Quotienten der Differenz des ersten und zweiten Stromstärkewerts sowie der Differenz des ersten und zweiten Spannungswerts.

Dadurch, dass die Impedanz bzw. der Innenwiderstand des Akkumulators in einem direkten Zusammenhang mit der Kapazität und Leistungsfähigkeit des Akkumulators steht, kann durch den ermittelten Impedanz- bzw. Innenwiderstandswert die tatsächliche Kapazität und Leistungsfähigkeit des Akkumulators bestimmt werden. Je höher die Impedanz bzw. der Innenwiderstand des Akkumulators desto niedriger ist die Kapazität und Leistungsfähigkeit des Akkumulators. Die tatsächliche Kapazität und Leistungsfähigkeit des Akkumulators kann auch als der Gesundheitszustand (SoH) des Akkumulators bezeichnet werden.

Bei dem Verfahrensschritt des Einstellens des Akkumulators von einem ersten Ladezustand in einen zweiten Ladezustand kann es sich entweder um einen Ladevorgang, bei dem elektrische Energie von einem Ladegerät zu dem Akkumulator gelangt, oder um einen Entladevorgang, bei dem elektrische Energie von dem Akkumulator zu einer Werkzeugmaschine gelangt, handeln.

Gemäß einer vorteilhaften Ausgestaltung der vorliegenden Erfindung kann es möglich sein, dass der erste Spannungswerte nach Ablauf einer dritten vorbestimmten Zeitdauer nach Erreichen des ersten Stromstärkewerts ermittelt wird. Die dritte vorbestimmte Zeitdauer beträgt zwischen 1 und 5 Sekunden, insbesondere 3 Sekunden und dient zur Relaxation und damit für eine genauere Bestimmung der Akku- bzw. Zell-Spannung.

Die spezifische Spannung Akkumulators, d.h. die maximale, nominelle oder minimale Spannung, ergibt sich aus der jeweiligen Akku-Zellentechnologie sowie aus der Anzahl an Akku-Zellen, die im Inneren des Akkumulators in Reihe geschaltet sind.

Die Kapazität wird typischerweise in Ampere-Stunden (Ah) angegeben bzw. gemessen und bezeichnet die elektrische Ladung, die der Akkumulator enthalten kann. Sie berechnet sich aus der Kapazität einer einzelnen Akku-Zelle und aus der Anzahl an Akku-Zellen, die im Akkumulator in Parallel geschaltet (bzw. parallelgeschaltet) sind. Bei einer gegebenen Akkuspannung bedeutet dabei eine höhere Kapazität, dass der Akkumulator mehr Energie speichern kann.

Zur Angabe der Leistungsfähigkeit eines Akkumulators wird beispielsweise der maximale Strom angegeben, den ein Akkumulator liefern kann. Da die Akku-Zellen sich bei hohen Strömen erwärmen und nur in einem bestimmten Temperaturbereich betrieben werden dürfen, kann die Leistungsfähigkeit des Akkumulators auch durch einen Strom, den der Akkumulator für eine bestimmte Zeit oder bis zur kompletten Entladung liefern kann, beschrieben werden. Die Leistungsfähigkeit ist sehr stark abhängige von der Impedanz (Wechselstromwiderstand) des Akkumulators. Die Impedanz kann auch als Innenwiderstand der Akku-Zellen bzw. des Akkumulators.

Akkumulatoren für die Versorgung einer Werkzeugmaschine enthalten typischerweise Litiumlonen-Zellen (Li-lon), die mit gewöhnlichen Ladegeräten in der Regel in einem sogenannten CCCV-Verfahren (Constant Current: konstanter Stromstärke; Constant Voltage: konstante Spannung) mit elektrischer Energie aufgeladen werden. Dabei generiert eine Ladeelektronik des Ladegeräts einen konstanten Ladestrom durch den Akkumulator (Constant Current - CC), so dass die Akkuspannung steigt. Sobald eine maximale Akkuspannung erreicht ist, wird diese von der Ladeelektronik konstant gehalten (Constant Voltage - CV) und der Ladestrom wird entsprechend reduziert. Ist ein vordefinierter Minimalwert des Ladestroms erreicht, beendet die Ladeelektronik den Ladevorgang und die Akku-Zellen sind vollgeladen. Der Übergang von der CC-Phase zu der CV-Phase erfolgt typischerweise bei einem Ladezustand (d.h. Kapazität) von ungefähr 80%.

Die Akkuspannung des Akkumulators ist in der Regel ein Vielfaches der Spannung einer einzelnen Akku-Zelle und ergibt sich aus der parallelen oder seriellen Verschaltung der Akku-Zellen. Bei Li-Ion-Akku-Zellen mit einer Zellspannung von 3,6 V ergeben sich somit beispielhafte Akkuspannungen von 3,6V, 7,2V, 10,8V, 14,4V, 18V, 36V etc. Bevorzugt ist die Akku-Zelle als zumindest im Wesentlichen zylinderförmige Rundzelle ausgebildet, wobei die Zellpole an Enden der Zylinderform angeordnet sind. Die elektrische Schnittstelle umfasst insbesondere zumindest zwei elektrische Kontaktelemente, die zur Übertragung von Energie ausgebildet sind. Alternativ kann die elektrische Schnittstelle aber auch ein sekundäres Ladespulenelement zur induktiven Ladung aufweisen.

In einer besonderen Ausgestaltung der Erfindung wird der Aufladevorgang mit dem CCCV-Verfahren durchgeführt, wobei zur Bestimmung der Restkapazität der erste Ladewert vor der CC-Phase und die weiteren Ladewerte während der CC-Phase und der CV-Phase ermittelt werden. Somit wird vor der CC-Phase die Leerlaufspannung gemessen und im Anschluss ein so genanntes "Coulumb Counting" durchgeführt, das zur Bestimmung der Ladung im Akkumulator die Anzahl der Elektronen erfasst.

Die Bestimmung der restlichen Leistungsfähigkeit des Akkumulators erfolgt vorzugsweise während der CC-Phase, indem der Ladestrom nach Erreichen der vordefinierten Akkuspannung für eine bestimmte Zeitdauer von einem ersten Wert auf einen zweiten Wert reduziert wird. Zudem kann zur Bestimmung der restlichen Leistungsfähigkeit des Akkumulators jeweils eine Wartezeit nach Veränderung des Ladestroms verstreichen, bis die Akkuspannung gemessen wird. Weiterhin ist vorgesehen, dass die Bestimmung der restlichen Leistungsfähigkeit in regelmäßigen Zeitabständen während des Aufladevorgangs, insbesondere während der CC-Phase, wiederholt wird.

Die Erhöhung der Impedanz im Laufe der Zeit ist ein Effekt der Alterung der Akku-Zellen. Die Impedanz der stromführenden Elemente (Kontakte, Leiterbahnen, Kabel, usw.) im Akkumulator oder im Ladegerät verändert sich dagegen nur vernachlässigbar. Es ist also besonders vorteilhaft, die Spannungsmessungen direkt im Akkumulator zu realisieren, um die Impedanzen der stromführenden Elemente zu ignorieren. Es können entweder die Spannung in den einzelnen Akku-Zellen oder die Spannung im gesamten Akkumulator ermittelt werden. Diese Impedanz-Messung kann entweder einmal oder mehrmals während des Ladevorgangs stattfinden. Mehrere Messungen erlauben eine Plausibilisierung und damit eine Vermeidung von Messfehlern, aber auch eine präzisere und detailliertere Abschätzung.

Die Restkapazität, die restliche Leistungsfähigkeit und/oder der Gesundheitszustand des Akkumulators können mit besonderem Vorteil auf einer externen Anzeigeeinheit ausgegeben werden. Dabei kann als Anzeigeeinheit sowohl ein Display (LCD, OLED, ePaper oder dergleichen) als auch eine LED-Anzeige des Akkumulators, des Ladegeräts oder alternativ bzw. ergänzend ein Smartphone, Tablet, PC oder dergleichen dienen. Die Kommunikation zwischen dem Akkumulator und den genannten Anzeigeeinheiten erfolgt über eine entsprechende Kommunikationsschnittstelle. Dabei kann ein proprietärer BUS verwendet werden, wie eine Übertragung per Standard- Protokolle per Kabel oder Funk.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen:

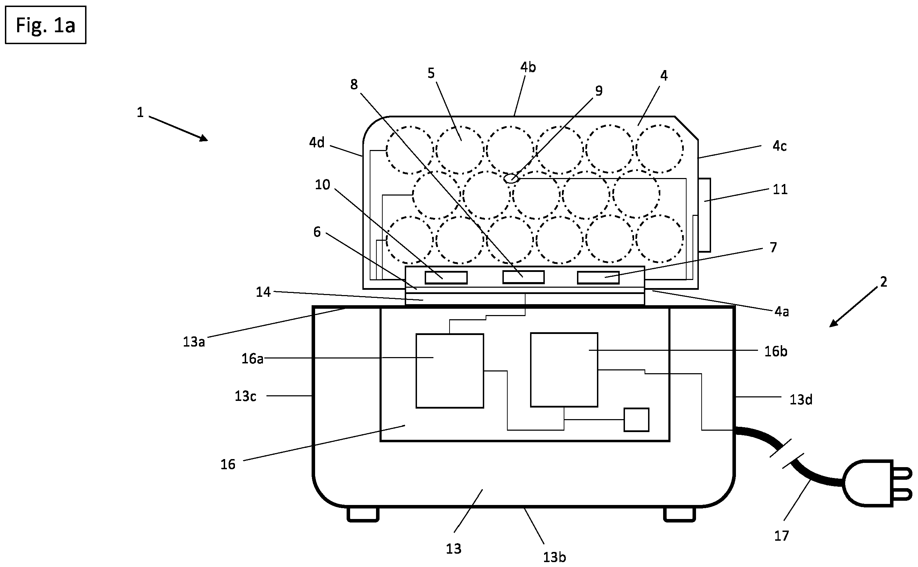

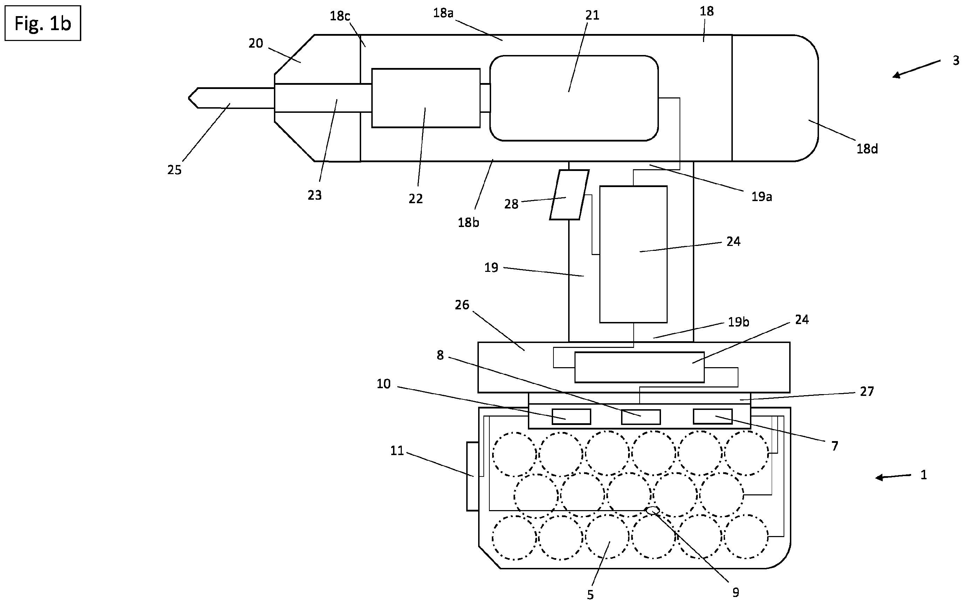

Figur 1a     eine Schnittansicht durch einen Akkumulator verbunden mit einem Ladegerät;

Figur 1     b eine Schnittansicht durch den Akkumulator verbunden mit einer Werkzeugmaschine;

Figur 2     ein schematische Diagramm zur Darstellung des Verfahrens zum Steuern und Regeln eines Akkumulators;

Figur 3     eine grafische Darstellung eines CCCV-Ladevorgangs; und

Figur 4     ein grafische Darstellung zur Veranschaulichung des Bestimmen eines Impedanzwertes des Akkumulators.

**Ausführunasbeispiele:**

Figur 1a zeigt einen Akkumulator 1 wiederlösbar verbunden mit einem Ladegerät 2.

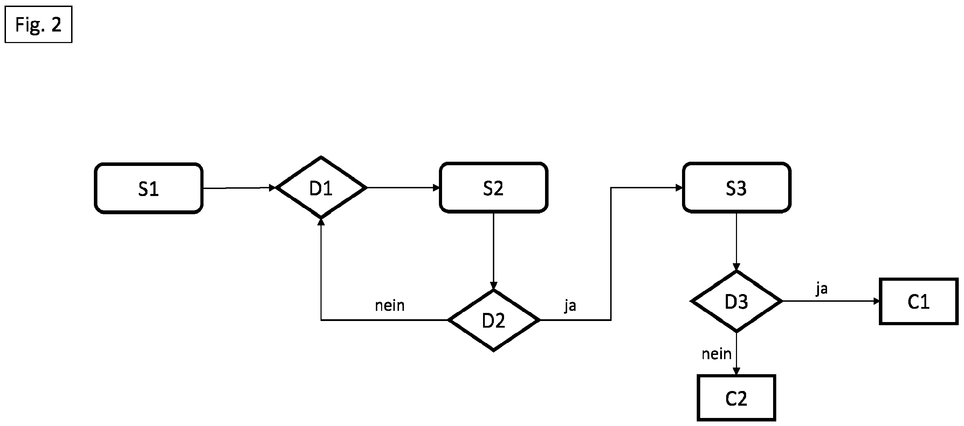

Der Akkumulator 1 kann als Energieversorgung für eine Werkzeugmaschine 3 verwendet werden. Die Werkzeugmaschine 3 ist in Form eines Akku-Schraubers in Figur 2 dargestellt.

Der Akkumulator 1 enthält im Wesentlichen ein Akku-Gehäuse 4, eine Anzahl an Energiespeicherzellen 5, eine Akku-Schnittstelle 6, eine Strommesseinrichtung 7, eine Spannungsmesseinrichtung 8, einen Temperatursensor 9, eine Akku-Speichereinrichtung 10, eine Anzeige- und Eingabeeinrichtung 11 sowie eine Akku-Steuerungseinrichtung 12.

Das Akku-Gehäuse 4 enthält eine Oberseite 4a, eine Unterseite 4b, eine linke Seitenwand, eine rechte Seitenwand, eine Vorderseite 4c und eine Rückseite. In Figur 1a ist lediglich die Oberseite 4a, Unterseite 4b, die Vorderseite 4c und die Rückseite 4d gezeigt.

Die Akku-Schnittstelle 6 ist an der Oberseite 4a des Akku-Gehäuses 4 positioniert und dient zum wiederlösbaren Verbinden des Akkumulators 3 mit dem Ladegerät 2 oder einer Werkzeugmaschine 3. Die Akku-Schnittstelle 6 enthält hierzu eine mechanische Ankopplungseinrichtung, eine elektrische Verbindungseinrichtung sowie einen Kommunikationsanschluss. Weder die mechanische Ankopplungseinrichtung, die elektrische Verbindungseinrichtung noch der Kommunikationsanschluss ist in den Figuren gezeigt.

In den Figuren ist die mechanische Ankopplungseinrichtung, die elektrische Verbindungseinrichtung und der Kommunikationsanschluss der Akku-Schnittstelle 6 nicht gezeigt.

Durch die mechanische Ankopplungseinrichtung kann der Akkumulator 1 form- und kraftschlüssig entweder mit dem Ladegerät 2 oder mit einer Werkzeugmaschine 3 verbunden werden. Mit Hilfe der elektrischen Verbindungseinrichtung kann elektrische Energie von dem Ladegerät 2 zu dem Akkumulator 1 gelangen, wenn der Akkumulator 1 mit dem Ladegerät 2 verbunden ist. Ebenso kann elektrische Energie von dem Akkumulator 1 zu einer Werkzeugmaschine 3 gelangen, wenn de Akkumulator 1 mit der Werkzeugmaschine 3 verbunden ist. Der Kommunikationsanschluss dient dazu, dass Informationen und Daten in Form von Signale zwischen dem Akkumulator 1 und dem Ladegerät 2 bzw. zwischen dem Akkumulator 1 und der Werkzeugmaschine 3 ausgetauscht werden können. Zu den Informationen und Daten können unter anderem Lade- oder Entladeparameter, Temperaturwerte, Ladezustand (State of Charge - SOC), der Gesundheitszustand (State of Health - SOH), (Rest-)Kapazität, Spannung, Stromstärke oder dergleichen gehören.

Die Akku-Steuerungseinrichtung 12 ist im Wesentlichen in der Nähe der Oberseite des Akku-Gehäuses 4 positioniert und dient zum Steuern sowie Regeln der unterschiedlichen Funktionen des Akkumulators 1.

Die Energiespeicherzellen 5 sind im Inneren des Akku-Gehäuses 4 in drei Reihen positioniert, sodass zwischen der zweiten und dritten Reihe der Energiespeicherzellen 5 der Temperatursensor 9 positioniert ist. Der Temperatursensor 9 dient zum Erfassen der Temperatur im Inneren des Akkumulator 1 an einer der zentral positionierten Energiespeicherzellen 5. Der Temperatursensor 9 ist über eine Leitung mit der Akku-Steuerungseinrichtung 12 verbunden. Da die Energiespeicherzellen 5 im Inneren bzw. in der Mitte des Akkumulators 1 während des Lade- oder Entladevorgangs für gewöhnlich die höchsten Temperaturen ausweisen, kann ein Temperatursensor 9, der an dieser zentral positionierten Energiespeicherzelle 5 die Temperatur erfasst, die höchste Temperatur und damit am schnellsten eine kritisch hohe Temperatur für den Akkumulator 1 feststellen.

Des Weiteren ist innerhalb der Akku-Steuerungseinrichtung 12 die Strommesseinrichtung 7, die Spannungsmesseinrichtung 8 und die Akku-Speichereinrichtung 10 enthalten.

Die Strommesseinrichtung 7 dient zum Erfassen bzw. Messen der Stromstärke an den einzelnen Energiespeicherzellen 5. Wie in Figur 1a angedeutet ist die Strommesseinrichtung 7 daher mit jeder einzelnen Energiespeicherzelle 5 verbunden. Durch das Erfassen bzw. Messen der Stromstärke an der einzelnen Energiespeicherzelle 5 kann die Stromstärke für den gesamten Akkumulator 1 ermittelt werden.

Die Spannungsmesseinrichtung 8 dient zum Erfassen bzw. Messen der Spannung an den einzelnen Energiespeicherzellen 5. Wie in Figur 1a angedeutet ist die Spannungsmesseinrichtung 8 daher mit jeder einzelnen Energiespeicherzelle 5 verbunden. Durch das Erfassen bzw. Messen der Spannung an der einzelnen Energiespeicherzelle 5 kann die Spannung für den gesamten Akkumulator 1 ermittelt werden.

Die Speichereinrichtung 10 dient zum Speichern und Bereitstellen unterschiedlichster Informationen und Daten, wie z.B. Look-Up-Tabellen für die verschiedenen Lade- oder EntladeParameter des Akkumulators 1. Zu diesen Parametern gehören unter anderem Temperaturverläufe bzw. Schwellwerte für Spannungen oder Stromstärken.

Die Anzeige- und Eingabeeinrichtung 11, welche auch als Human-Machine-Interface (HMI) bezeichnet werden kann, ist an der Vorderseite des Akku-Gehäuses 4 positioniert. Wie in Figur 1a angedeutet ist die Anzeige- und Eingabeeinrichtung 11 mit der Akku-Steuerungseinrichtung 12 verbunden, sodass unterschiedliche Daten und Informationen auf einem Anzeigeanteil der Anzeige- und Eingabeeinrichtung 11 ersichtlich sind. Insbesondere kann der Ladezustand bzw. die Kapazität des Akkumulators 1 auf dem Anzeigeanteil angezeigt werden.

Auf einem Eingabeanteil der Anzeige- und Eingabeeinrichtung 11 kann ein Anwender unterschiedliche Betriebszustände (oder auch Betriebsmodi oder Modi genannt) für den Akkumulator 1 ausgewählt und eingestellt werden. Zu den unterschiedlichen Betriebszuständen zählen beispielsweise bestimmte Lade- oder Entladezustände. Bei einem ersten auswählbaren Betriebszustand wird für den Akkumulator 1 ein CCCV-Ladeverfahren eingestellt. Bei einem zweiten auswählbaren Betriebszustand wird für den Akkumulator 1 ein Schnellladeverfahren eingestellt, bei dem mit relativ hohen Ladeströmen eine relativ kurze Ladezeit erreicht werden kann. Bei einem dritten auswählbaren Betriebszustand wird für den Akkumulator 1 ein langsames und schonendes Ladeverfahren eingestellt, bei dem mit relativ niedrigen Ladeströmen zwar eine relativ lange Ladezeit, aber auch ein für die Energiespeicherzellen 5 schonendes (d.h. wenig belastendes) Laden erreicht werden kann.

Das Ladegerät 2 enthält ein Ladegerät-Gehäuse 13, ein Ladegerät-Schnittstelle 14, eine Ladegerät-Speichereinrichtung 15 sowie eine Ladegerät-Steurungseinrichtung 16.

Die Ladegerät-Steuerungseinrichtung 16 enthält eine Strommesseinrichtung 16a und eine Spannungsmesseinrichtung 16b.

Das Ladegerät-Gehäuse 13 enthält eine Oberseite 13a, eine Unterseite 13b, eine linke Seitenwand, eine rechte Seitenwand, eine Vorderseite 13c und eine Rückseite 13d. In Figur 1a ist lediglich die Oberseite 13a, Unterseite 13b, die Vorderseite 13c und die Rückseite 13d gezeigt.

Die Ladegerät-Schnittstelle 14 ist an der Oberseite 13a des Ladegerät-Gehäuses 13 positioniert und dient zum wiederlösbaren Verbinden des Ladegeräts 2 mit dem Akkumulator 1. Die Ladegerät-Schnittstelle 14 enthält hierzu eine mechanische Ankopplungseinrichtung, eine elektrische Verbindungseinrichtung sowie einen Kommunikationsanschluss.

Die mechanische Ankopplungseinrichtung, die elektrische Verbindungseinrichtung und der Kommunikationsanschluss des Ladegeräts 2 sind zu der mechanischen Ankopplungseinrichtung, der elektrischen Verbindungseinrichtung und dem Kommunikationsanschluss des Akkumulators 1 korrespondierend ausgestaltet, sodass die Komponenten der Ladegerät-Schnittstelle 14 und der Akku-Schnittstelle 6 entsprechend miteinander verbunden werden können.

In den Figuren ist die mechanische Ankopplungseinrichtung, die elektrische Verbindungseinrichtung und der Kommunikationsanschluss der Ladegerät-Schnittstelle 14 nicht gezeigt.

Des Weiteren verfügt das Ladegerät 2 über ein Stromanschlusskabel 17, welches aus dem Ladegerät-Gehäuse 14 herausragt und mit der Ladegerät-Steuerungseinrichtung 16 verbunden ist. Das Stromanschlusskabel 17 dient zum wiederlösbaren Verbinden des Ladegeräts 2 mit einer Netzstromquelle (Steckdose).

Figur 2 zeigt den Akkumulator 1 wiederlösbar verbunden mit der Werkzeugmaschine 3. Wie bereits vorstehend beschriebenen Werkzeugmaschine 3 ist in Figur 2 als Akku-Schrauber ausgestaltet. Alternativ kann die Werkzeugmaschine 3 auch als Bohrhammer, Bohrmaschine, Säge, Schleifgerät oder dergleichen ausgestaltet sein. Die als Akku-Schrauber ausgestaltete Werkzeugmaschine 3 enthält im Wesentlichen ein Gehäuse 18, einen Handgriff 19 sowie eine Werkzeugaufnahme 20.

Das Gehäuse 18 der Werkzeugmaschine 2 enthält wiederum eine Oberseite 18a, eine Unterseite 18b, ein vorderes Ende 18c und ein hinteres Ende 18d. Im Inneren des Gehäuses 18 ist im Wesentlichen ein Antrieb 21, ein Getriebe 22, eine Abtriebswelle 23 und eine Steuervorrichtung 24 enthalten. Der Antrieb 21 ist als Elektromotor ausgestalte und dient zum Erzeugen eines Drehmoments. Wie in Figur 2 gezeigt ist der Antrieb 21, das Getriebe 22, die Abtriebswelle 23 und die Werkzeugaufnahme 20 so zueinander angeordnet, dass ein von dem Antrieb 21 erzeugtes Drehmoment über das Getriebe 22 und die Abtriebswelle 23 auf die Werkzeugaufnahme 20 übertragen werden kann.

An dem vorderen Ende 18c ist die Werkzeugaufnahme 20 positioniert, die zum Aufnehmen und Halten eines Werkzeugs 25 dient. Bei dem Werkzeug 25 handelt es sich um ein Schrauber-Bit.

Der Handgriff 19 dient zum Halten und Führen der Werkzeugmaschine 3 durch einen (nicht gezeigten) Anwender. Der Handgriff 19 enthält dabei ein oberes Ende 19a und ein unteres Ende 19b. Der Handgriff 19 ist mit dem oberen Ende 19a an der Unterseite 19b des Gehäuses 19 der Werkzeugmaschine 2 befestigt. An dem unteren Ende 19b des Handgriffs 19 ist eine Fussvorrichtung 26 mit einer Werkzeugmaschinen-Schnittstelle 27 positioniert.

Des Weiteren weist der Handgriff 19 einen Aktivierungsschalter 28 auf, der mit der Steuereinrichtung 24 verbunden ist. Durch den Aktivierungsschalter 28 kann ein Anwender die Werkzeugmaschine 2 je nach Positionierung des Aktivierungsschalter 28 in einen Aktivierungsoder Deaktivierungszustand versetzen. In einem Aktivierungszustand erzeugt der Antrieb 21 ein Drehmoment.

Die Werkzeugmaschinen-Schnittstelle 27 dient zum wiederlösbaren Verbinden der Werkzeugmaschine 3 mit dem Akkumulator 1. Die Werkzeugmaschinen-Schnittstelle 27 enthält hierzu eine mechanische Ankopplungseinrichtung, eine elektrische Verbindungseinrichtung sowie einen Kommunikationsanschluss.

Die mechanische Ankopplungseinrichtung, die elektrische Verbindungseinrichtung und der Kommunikationsanschluss der Werkzeugmaschine 3 sind zu der mechanischen Ankopplungseinrichtung, der elektrischen Verbindungseinrichtung und dem Kommunikationsanschluss des Akkumulators 1 korrespondierend ausgestaltet, sodass die Komponenten der Werkzeugmaschine 3 und der Akku-Schnittstelle 6 entsprechend miteinander verbunden werden können.

In den Figuren ist die mechanische Ankopplungseinrichtung, die elektrische Verbindungseinrichtung und der Kommunikationsanschluss der Werkzeugmaschine 3 nicht gezeigt.

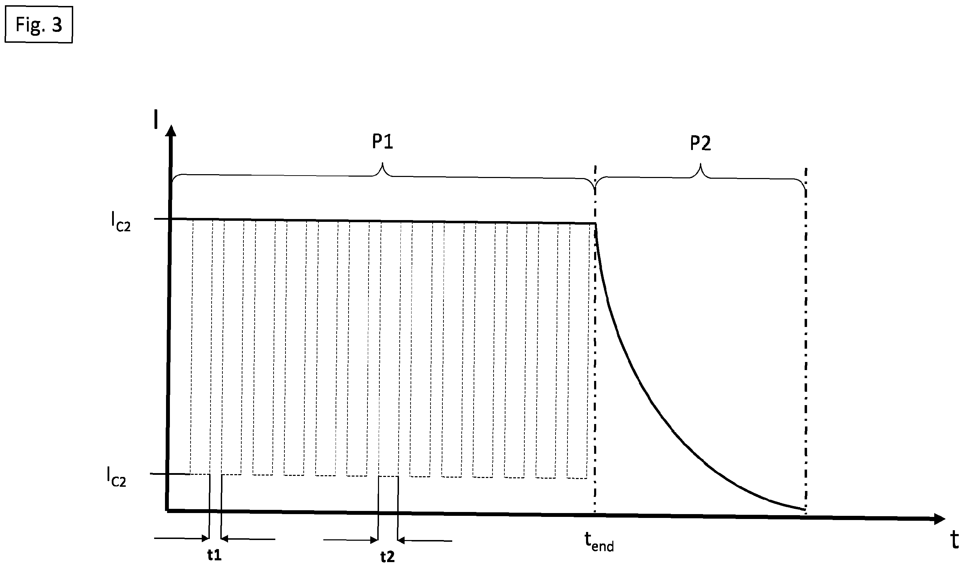

Figur 3 zeigt grafische Darstellung eines CCCV-Ladevorgangs, wobei das Ladegerät 2 einen konstanten Ladestrom (CC — constant current) $I_{C2}$ in der Phase P1 bereitstellt bis eine maximale Akku-Spannung erreicht wurde. Ab einem Zeitpunkt $t_{end}$ wird während einer zweiten Phase P2 der Wert des Ladestroms $I_{C2}$ kontinuierlich reduziert, wobei die Akku-Spannung konstant (CV - constant voltage) bleibt.

Figur 2 zeigt ein schematisches Diagramm zur Darstellung des Verfahrens zum Steuern und Regeln eines Akkumulators 1 während eines Ladens des Akkumulators 1.

Zur Durchführung des Verfahrens wird zunächst im Verfahrensschritt S1 der Akkumulator 1 mit dem Ladegerät 2 so verbunden, dass die entsprechenden mechanischen Ankopplungseinrichtungen, die elektrischen Verbindungseinrichtungen und die Kommunikationsanschlüsse des Akkumulators 1 und des Ladegeräts 2 miteinander gekoppelt sind. Durch die Kopplung der Kommunikationsanschlüsse des Akkumulators 1 und des Ladegeräts 2 werden Daten und Informationen bezüglich der Ladespezifikation bzw. Ladeparameter, insbesondere Schwellwerte für eine maximalen Ladestrom oder eine maximale Ladespannung zwischen dem Akkumulator 1 und dem Ladegerät 2 ausgetauscht. Durch das Verbinden der elektrischen Verbindungseinrichtungen des Akkumulators 1 und des Ladegeräts 2 wird elektrische Energie von dem Ladegerät 2 zum Akkumulator 1 geleitet, wobei ein Wert für eine Ladestromstärke $I_{C2}$ an dem Ladegerät 2 eingestellt ist. Das Einstellen des Wertes für die Ladestromstärke $I_{C2}$ erfolgt dabei durch ein entsprechendes Signal von dem Akkumulator 1 über die Kommunikationsanschlüsse an das Ladegerät 2. Die Ladespannung $U_{R1}$ bei der eine Ladestromstärke $I_{C2}$ wird mit Hilfe der Spannungsmesseinrichtung 8 des Akkumulators 1 erfasst. Alternativ kann die Ladespannung $U_{R1}$ bei der eine Ladestromstärke $I_{C2}$ wird mit Hilfe der Spannungsmesseinrichtung 16b des Ladegeräts 2 erfasst werden. Der erfasste Wert für die Ladespannung $U_{R1}$ wird in der Akku-Speichereinrichtung 10 gespeichert. Alternativ kann der erfasste Wert für die Ladespannung $U_{R1}$ in der Ladegerät-Speichereinrichtung 15 gespeichert werden.

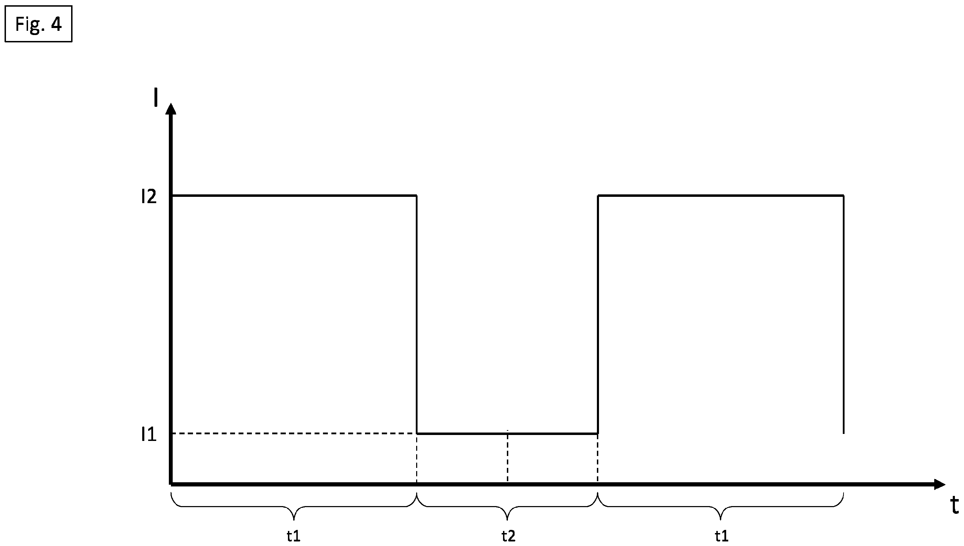

Nach einer ersten Zeitdauer t1 (vgl. Figur 4) und an einem Verfahrensschritt D1 wird in einem zweiten Verfahrensschritt S2 ein erster Stromstärkewert $I_{C1}$ zum Laden des Akkumulators 1 eingestellt, wobei der erste Stromstärkewert $I_{C1}$ niedriger ist als der Ladestromstärkewert $I_{C2}$ eingestellt. Das Einstellen des Stromstärkewertes erfolgt durch die Akku-Steuerungseinrichtung 12 oder gemäß einer alternativen Ausführungsform der Erfindung durch die Ladegerät-Steuerungseinrichtung 16.

Der erste Stromstärkewert $I_{C1}$ kann dabei 0A (in Worten: null Amper) betragen.

Die erste Zeitdauer t1 beträgt 5 bis 10 Sekunden. Darüber hinaus wird während des zweiten Verfahrensschritts S2 die Temperatur des Akkumulators 1 und die Akku-Spannung bzw. die Ladespannung $U_{R2}$ erfasst.

Gemäß einer alternativen Ausführungsform der vorliegenden Erfindung wird nicht nach einer ersten Zeitdauer D1 (bzw. t1 in Figur 4), sondern nach Erreichen eines vorbestimmten Temperaturwertes, nach Erreichen eines vorbestimmten Stromstärkewertes oder wenn die Differenz zwischen einem ersten und zweiten ermittelten Stromstärkewert einen vorbestimmten Schwellwert erreicht ein erster Stromstärkewert $I_{C1}$ zum Laden des Akkumulators 1 eingestellt. Während des zweiten Verfahrensschritt S2 wird mit Hilfe der Formel F1 die Impedanz Z des Akkumulators aus dem Quotienten der Differenz des ersten Stromstärkewerts $I_{C1}$ und zweiten Stromstärkewerts $I_{C2}$ sowie der Differenz des ersten Spannungswerts $U_{R1}$ und zweiten Spannungswerts $U_{R2}$ bestimmt.

Formel F1:

$$Z = |(U_{R1} - U_{R2})/(I_{c1} - I_{c2})|$$

Nach der Zeitdauer t2 wird der zweite Stromstärkewert $I_{C2}$ wieder auf den ersten Stromstärkewert $I_{C1}$ eingestellt, vgl. Figur 4.

Die Impedanz des Akkumulators 1 steht in einem direktem Zusammenhang mit der Temperatur des Akkumulators 1 bzw. dessen Energiespeicherzellen 5. Die Temperatur wird daher mit des Temperatursensor 9 während des Bestimmens der Impedanz in Phase P1 erfasst. Mit Hilfe der Steuerungseinrichtung und der in der Speichereinrichtung hinterlegten Look-Up-Tabellen für die Temperaturwerte kann ein die Impedanz in Abhängig zu der jeweils erfassten Temperatur des Akkumulators 1 bestimmt werden. Die erfassten Temperaturwerte werden in der Speichereinrichtung gespeichert. Alternativ kann mit Hilfe der Look-Up-Tabellen für die Temperaturwerte ein normalisierten Wert für die Impedanz bei einer Temperatur von 25°C bestimmt werden.

Wie in Figur 3 angedeutet, wird während der gesamten Phase P1 gemäß eines Ausführungsbeispiels der vorliegenden Erfindung in regelmäßigen Zeitabständen eine Bestimmung der Impedanz Z mit Hilfe des vorstehend beschriebenen Verfahrens durchgeführt.

An dem Verfahrensschritt D2 wird entschieden, ob der Ladevorgang für den Akkumulator 1 beendet werden soll oder nicht. Wenn der Ladevorgang fortgesetzt werden soll, wird nach einer weiteren Zeitdauer t1 die Impedanz Z erneut bestimmt.

Für die Phase P1 werden die bestimmten Werte der Impedanz in der Speichereinrichtung gespeichert, sodass eine gewisse Anzahl an Impedanzwerten vorliegen. In dem Verfahrensschritt S3 kann ein mittlerer Impedanzwert aus der Vielzahl an bestimmten Impedanzwerten berechnet werden, welcher relativ robust gegen mögliche Ladezustands- und Temperaturabhängigkeiten ist. Durch die Verwendung einer Vielzahl an berechneten mittleren Impedanzwertes kann über die gesamte Einsatzzeit des Akkumulators die Kapazität und Leistungsfähigkeit des Akkumulators 1 bestimmt werden.

An dem Verfahrenspunkt D3 kann entschieden werden, ob der mittlerer Impedanzwert einen vorbestimmten Impedanz-Schwellwert erreicht hat, oder nicht. Der vorbestimmte Impedanz-Schwellwert ist in der Speichereinrichtung hinterlegt. Wenn der Schwellwert der ermittelten mittleren Impedanz erreicht wurde, ist die Kapazität und Leistungsfähigkeit des Akkumulators 1 für eine weitere Verwendung als Energieversorgung einer Werkzeugmaschine 3 nicht mehr ausreichend. Die Verwendung, d.h. das Laden und Entladen des Akkumulators 1 kann daraufhin durch die Steuerungseinrichtung 10 des Akkumulators 1 gesperrt werden.

Das vorstehende erfindungsgemäße Verfahren beschreibt einen Ladevorgang des Akkumulators 1 an dem Ladegerät 2. Das erfindungsgemäße Verfahren kann jedoch auch für einen Entladevorgang des Akkumulators 1 als Energieversorgung an einer Werkzeugmaschine 3 verwendet werden. Das Verfahren bei einem Entladevorgang des Akkumulators 1 ist dem Ladevorgang des Akkumulators 1 nahezu identisch. Im Gegensatz zu dem Verfahren bei dem Ladevorgang des Akkumulators 1 gelangt bei dem Entladevorgang elektrische Energie von dem Akkumulator 1 zu der Werkzeugmaschine 3.

**Bezuaszeichenliste**

| | |
|---|---|
| 1 | Akkumulator |
| 2 | Ladegerät |
| 3 | Werkzeugmaschine |
| 4 | Akku-Gehäuse |
| 4a | Oberseite des Akku-Gehäuses |
| 4b | Unterseite des Akku-Gehäuses |
| 4c | Vorderseite des Akku-Gehäuses |
| 4d | Rückseite 4d des Akku-Gehäuses |
| 5 | Energiespeicherzelle |
| 6 | Akku-Schnittstelle |
| 7 | Strommesseinrichtung des Akkumulators |
| 8 | Spannungsmesseinrichtung des Akkumulators |
| 9 | Temperatursensor des Akkumulators |
| 10 | Akku-Speichereinrichtung |
| 11 | Anzeige- und Eingabeeinrichtung |
| 12 | Akku-Steuerungseinrichtung |
| 13 | Ladegerät-Gehäuse |
| 13a | Oberseite des Ladegerät-Gehäuses |
| 13b | Unterseite des Ladegerät-Gehäuses |
| 13c | Vorderseite des Ladegerät-Gehäuses |
| 13d | Rückseite des Ladegerät-Gehäuses |
| 14 | Ladegerät-Schnittstelle |
| 15 | Ladegerät-Speichereinrichtung |
| 16 | Ladegerät-Steuerungseinrichtung |
| 16a | Strommesseinrichtung |
| 16b | Spannungsmesseinrichtung |
| 17 | Stromanschlusskabel |
| 18 | Gehäuse der Werkzeugmaschine |
| 18a | Oberseite des Werkzeugmaschinengehäuses |
| 18b | Unterseite des Werkzeugmaschinengehäuses |
| 18c | vorderes Ende des Werkzeugmaschinengehäuses |
| 18d | hinteres Ende des Werkzeugmaschinengehäuses |
| 19 | Handgriff |
| 19a | oberes Ende des Handgriffs |
| 19b | unteres Ende des Handgriffs |
| 20 | Werkzeugaufnahme |
| 21 | Antrieb |
| 22 | Getriebe |
| 23 | Abtriebswelle |
| 24 | Steuervorrichtung |
| 25 | Werkzeug |
| 26 | Fussvorrichtung |
| 27 | Werkzeugmaschinen-Schnittstelle |
| 28 | Aktivierungsschalter |

**Patentansprüche**

1. Verfahren zum Steuern und Regeln eines Akkumulators (1) zur Versorgung einer Werkzeugmaschine (2) mit elektrischer Energie, wobei der Akkumulator (1) wenigstens eine Energiespeicherzelle (5), wenigstens einen Temperatursensor (9), eine Strommesseinrichtung (7), eine Spannungsmesseinrichtung (8) sowie eine Akku-Steuerungseinrichtung (12) mit wenigstens einer Akku-Speichereinrichtung (10) enthält, **gekennzeichnet durch** die Verfahrensschritte

   - Einstellen des Akkumulators (1) von einem ersten Ladezustand in einen zweiten Ladezustand;
   - Erstellen eines ersten Stromstärkewertes nach Ablauf einer ersten vorbestimmten Zeitdauer, nach Erreichen eines vorbestimmten Temperaturwertes, nach Erreichen eines vorbestimmten Stromstärkewertes oder wenn die Differenz zwischen einem ersten und zweiten ermittelten Stromstärkewert einen vorbestimmten Schwellwert erreicht;
   - Ermitteln eines ersten Spannungswertes nach Erreichen des ersten Stromstärkewerts;
   - Einstellen eines zweiten Stromstärkewertes nach Ablauf einer zweiten vorbestimmten Zeitdauer;
   - Ermitteln eines zweiten Spannungswertes nach Erreichen des zweiten Stromstärkewerts; und
   - Bestimmen eines ersten Impedanzwertes (Z) des Akkumulators (1) aus dem Quotienten der Differenz des ersten und zweiten Stromstärkewerts sowie der Differenz des ersten und zweiten Spannungswerts.

2. Verfahren nach Anspruch 1,
   **dadurch gekennzeichnet, dass** der erste Spannungswerte nach Ablauf einer dritten vorbestimmten Zeitdauer nach Erreichen des ersten Stromstärkewerts ermittelt wird.

3. Akkumulator (1) zum Durchführen des Verfahrens nach Anspruch 1 oder 2,
   **dadurch gekennzeichnet, dass** der Akkumulator (1) wenigstens eine Energiespeicherzelle (5), wenigstens einen Temperatursensor (9), eine Strommesseinrichtung (7), eine Spannungsmesseinrichtung (8) sowie eine Akku-Steuerungseinrichtung (12) mit wenigstens einer Akku-Speichereinrichtung (10) enthält.

4. Ladegerät (2) zum Durchführen des Verfahrens nach Anspruch 1 oder 2,
   **dadurch gekennzeichnet, dass** das Ladegerät (2) eine Ladegerät-Steuerungseinrichtung (16) mit wenigstens einer Ladegerät-Speichereinrichtung (15)

enthält.

Fig. 1a

EP 4 137 831 A1

Fig. 1b

Fig. 2

S1 → D1 → S2

D2: nein, ja

S3

D3 → ja → C1

D3 → nein → C2

Fig. 3

EP 4 137 831 A1

Fig. 4

Europäisches Patentamt
European Patent Office
Office européen des brevets

# EUROPÄISCHER RECHERCHENBERICHT

Nummer der Anmeldung

EP 21 19 2300

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2018 220251 A1 (BOSCH GMBH ROBERT [DE]) 28. Mai 2020 (2020-05-28) * Absatz [0007] – Absatz [0037]; Abbildungen 1-4 * ----- | 1-4 | INV. G01R31/389 G01R31/392 H02J7/00 |
| X | WO 2021/063740 A1 (HILTI AG [LI]) 8. April 2021 (2021-04-08) * Seite 4, Zeile 2 – Seite 6, Zeile 20; Abbildung 1 * ----- | 3 | |
| A | US 5 541 490 A (SENGUPTA UPAL [US] ET AL) 30. Juli 1996 (1996-07-30) * das ganze Dokument * ----- | 1-4 | |
| A | DE 10 2019 000754 A1 (DIEHL AEROSPACE GMBH [DE]) 6. August 2020 (2020-08-06) * das ganze Dokument * ----- | 1-4 | |

**RECHERCHIERTE SACHGEBIETE (IPC)**

G01R
H02J
H01M

Der vorliegende Recherchenbericht wurde für alle Patentansprüche erstellt

| Recherchenort | Abschlußdatum der Recherche | Prüfer |
|---|---|---|
| **München** | **3. Februar 2022** | **Lyons, Christopher** |

**ANHANG ZUM EUROPÄISCHEN RECHERCHENBERICHT
ÜBER DIE EUROPÄISCHE PATENTANMELDUNG NR.**

EP 21 19 2300

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-02-2022

| Im Recherchenbericht angeführtes Patentdokument | Datum der Veröffentlichung | Mitglied(er) der Patentfamilie | Datum der Veröffentlichung |
|---|---|---|---|
| DE 102018220251 A1 | 28-05-2020 | CN 113167838 A | 23-07-2021 |
| | | DE 102018220251 A1 | 28-05-2020 |
| | | EP 3887837 A1 | 06-10-2021 |
| | | WO 2020108970 A1 | 04-06-2020 |
| WO 2021063740 A1 | 08-04-2021 | EP 3800722 A1 | 07-04-2021 |
| | | WO 2021063740 A1 | 08-04-2021 |
| US 5541490 A | 30-07-1996 | US 5541490 A | 30-07-1996 |
| | | US 5561361 A | 01-10-1996 |
| | | US 5629604 A | 13-05-1997 |
| | | US 5838141 A | 17-11-1998 |
| | | US 5847546 A | 08-12-1998 |
| | | US 5883497 A | 16-03-1999 |
| DE 102019000754 A1 | 06-08-2020 | KEINE | |

EPO FORM P0461

Für nähere Einzelheiten zu diesem Anhang : siehe Amtsblatt des Europäischen Patentamts, Nr.12/82